# EUROPÄISCHE PATENTSCHRIFT

(11) **EP 2 817 804 B1**
(45) Veröffentlichungstag und Bekanntmachung des Hinweises auf die Patenterteilung: **10.04.2019**
(21) Anmeldenummer: 13707813.5
(22) Anmeldetag: 21.02.2013
(51) Int. Cl.: G11C 16/34

(54) **VERLÄNGERUNG DER BETRIEBSZEIT EINES SICHERHEITSELEMENTS**
EXTENSION OF THE OPERATING TIME OF A SECURITY ELEMENT
ALLONGEMENT DU TEMPS DE FONCTIONNEMENT D'UN ÉLÉMENT DE SÉCURITÉ

(30) Priorität: 24.02.2012 DE 102012003710
(43) Veröffentlichungstag der Anmeldung: 31.12.2014
(73) Patentinhaber: Giesecke+Devrient Mobile Security GmbH, 81677 München (DE)
(72) Erfinder: RUDOLPH, Jens, 80639 München (DE); WIMBÖCK, Ulrich, 82327 Tutzing (DE); LEUTNER, Bernhard, 85604 Zorneding (DE)
(86) Internationale Anmeldenummer: PCT/EP2013/000509
(87) Internationale Veröffentlichungsnummer: WO 2013/124066

(56) Entgegenhaltungen:
- US-A1- 2011 035 535
- US-B1- 6 249 838
- US-B1- 7 356 442

## Beschreibung

Die Erfindung betrifft ein Verfahren und ein System zum Verlängern der Betriebszeit eines Sicherheitselements. Weiterhin betrifft die Erfindung eine Verwendung des Verfahrens in einem Sicherheitselements sowie ein Computerprogrammprodukt.

Bei einem Sicherheitselement handelt es sich beispielsweise um einen in Hardware ausgestalteten Datenträger. Das Sicherheitselement ist beispielsweise als ein fest integrierter Bestandteil in einem Endgerät angeordnet, wobei es entweder in der Form nicht vom Endgerät entnommen werden kann, beispielsweise als M2M Modul, Co-Prozessor, Trusted Base, Trusted Platform Module.

Alternativ ist das Sicherheitselement als ein entnehmbares Modul mit dem mobilen Endgerät verbunden, beispielsweise als Chipkarte, insbesondere einer Subscriber Identification Module, kurz SIM/USIM Karte, Smart Card, Massenspeicherkarte, USB-Token, Multimediakarte, Secure MicroSD-Karte, Mobilfunknetztoken, z.B. ein UMTS-Surfstick und/oder als elektronisches Identitätsdokument, beispielsweise als elektronischer Personalausweis beziehungsweise Reisepass mit, in einem Speicherbereich abgelegten maschinenlesbaren Identifikationsdaten einer Person.

Alternativ ist das Sicherheitselement eine Softwarekomponente und in der Form als vertrauenswürdiger Teil eines Betriebssystemkernels eines Endgerätes bzw. als ein Sicherheitssoftware-Algorithmus ausgestaltet, beispielsweise in der Verwendung als gesicherte Laufzeitumgebung zur Ausführung von Programmen bzw. Applikationen. Insbesondere kann als gesicherte Laufzeitumgebung die an sich bekannte ARM TrustZone® eingesetzt werden, auf der z.B. das ebenfalls bekannte Betriebssystem MobiCore® läuft.

Bei dem Sicherheitselement handelt es sich grundsätzlich um einen in Baugröße und Ressourcenumfang reduzierten Computer, der einen Mikrocontroller und mindestens eine Schnittstelle zur Kommunikation mit einem externen Gerät aufweist. Häufig besitzt er keine oder nur eine rudimentäre eigene Nutzerdatenausgabe. Das Sicherheitselement weist insbesondere einen Datenspeicher zum Ablegen von Daten, Informationen, Dateien und/oder Applikationen mit dazugehörigen Variablen ab, wobei Bereiche des Datenspeichers flüchtig oder nicht-flüchtig sein können. Der nichtflüchtige Datenspeicher kann insbesondere permanent, beispielsweise als ein Read-Only-Memory, kurz ROM oder semi-permanent sein, beispielsweise als ein Electrically-Erasable-Programmable-Read-Only-Memory, kurz EEPROM, Flashspeicher, Ferroelectric Random Access Memory, kurz FRAM bzw. FeRAM-Speicher oder Magnetoresistive Random Access Memory, kurz MRAM-Speicher.

Bei heutigen Sicherheitselementen ist die Anzahl der Schreib-/Löschzugriffe des semi-permanenten nichtflüchtigen Speichers begrenzt. Bei heutigen Speichertechnologien kann es zwingend sein, dass ein Löschzugriff erfolgen muss, bevor ein Schreibzugriff auf den Speicherteilbereich erfolgen kann. Im Folgenden wird dies auch unter dem Begriff Schreibzugriff verstanden. Bei EEPROM können je nach Logik Bits, Bytes oder Worte adressiert werden, beispielsweise 8,16 oder 32 Bit. Bei Flash-Speichern wird ein Speicherteilbereich, auch als Speicherseite oder Speicherpage bezeichnet, adressiert, beispielsweise 128 Bytes. Diese Anzahl sinkt mit zunehmender Leistungsfähigkeit und gleichzeitiger Flächenverkleinerung des Datenspeichers. Ein Hersteller derartiger nichtflüchtiger Speicher garantiert meist nur eine Maximalanzahl an Schreibzugriffereignissen pro Speicherteilbereich. Ist diese Anzahl von Schreibzugriffsereignissen erreicht, wird für die Funktionsfähigkeit des Datenspeichers keine Garantie übernommen. Wird das Sicherheitselement auch nach Erreichen des garantierten Maximalwerts an Zugriffsereignissen auf den Datenspeicher weiterhin betrieben, steigt das Risiko und die Wahrscheinlichkeit, dass der Datenspeicher nicht mehr funktionsfähig ist. In der Folge fällt das Sicherheitselement aus, was zu erheblichen Mehrkosten für den Betreiber bis hin zu Rückrufaktionen oder einem Endgeräteaustausch führen kann.

Problematisch hierbei ist, dass die Betriebszeit der Sicherheitselemente in Zukunft weiter gesteigert werden soll. So ist beispielsweise ein Kraftfahrzeug, ausgestattet mit einem Endgerät zur Aufnahme eines M2M Moduls mehrere Jahre in Betrieb, sodass der Datenspeicher eine im Vergleich zu heutigen SIM wesentlich höhere Betriebszeit erreichen muss. Damit einher muss auch der Datenspeicher für diese längere Betriebszeit gerüstet sein, da mit jeder Netzauthentisierung, M2M-Reset, OTA Softwareupdates etc. der Datenspeicher mit Zugriffsereignissen gestresst wird.

Alternativ werden zukünftig die Chipkarten in Mobilfunkendgeräten fest eingebaut sein, insbesondere als sogenannte Embedded-Universal-Integrated-Circuit-Card, kurz eUICC. Dann werden auf dem Mobilfunkendgerät in dessen Betriebszeit unterschiedliche Teilnehmerkennungen geladen, aktiviert, gelöscht und umgeschaltet, ein sogenanntes Over-The-Air Subscription Management, welches das häufige Zugreifen auf den nichtflüchtigen Speicher bedingt.

Auch die Erweiterbarkeit von Sicherheitselementen, insbesondere mit Applikationen aus dem Bereich der E-Services, wie E-payment, E-government, E-Vote, E-Education, E-Learning, E-Teaching, E-Publishing, E-Book, E-Catalog, E-Business, E-Commerce, E-Procurement, E-Shop, E-Intermediary, E-Auction, E-Culture, E-Consult und/oder E-Advising, führt zu einer Mehrbelastung des Datenspeichers des Sicherheitselements durch eine höhere Anzahl von Schriebzugriffen auf den Datenspeicher.

Zur Verlängerung der Betriebszeit von Datenspeichern in Flashtechnologie ist das sogenannte "Wear-Leveling" bekannt. Dazu wird auf dem Flashspeicher ein Flashcontroller zur Speicherverwaltung eingesetzt. Dieser Flashcontroller sorgt für eine gleichmäßige Auslastung/ Abnutzung des Datenspeichers. Zum Einen ist das Wear-Leveling auf die Flashtechnologie beschränkt, zum Anderen hat das Sicherheitselement über das Wear Leveling Verfahren im Flashcontroller keine Kontrolle, wodurch es ineffektiv und möglicherweise fehlerhaft eingesetzt wird.

Alternativ geben Hersteller von Sicherheitselementen stets den Hinweis, dass das Beschreiben des nichtflüchtigen Speichers auf ein Minimum zu reduzieren ist und insbesondere entsprechende Software-Routinen, beispielsweise Programmcodeschleifen, aufwendige Registerauswertungen etc., zu umgehen sind. Dabei ist nachteilig, dass sich ein Softwareprogrammierer in der Gestaltung des Softwarecodes einschränken muss. Dies beeinträchtigt die Leistungsfähigkeit, den Rechenaufwand und die Programmlaufzeit des Sicherheitselements.

In der DE 103 51 745 A1 wird vorgeschlagen, den Funktionszustand eines Sicherheitselements an einen Betreiber des Sicherheitselements zu melden. Dabei werden nur defekte Speicherteilbereiche ermittelt. Der Betreiber entscheidet dann, ab wann das Sicherheitselement auszutauschen ist.

In der DE 10 2008 056 710 A1 wird vorgeschlagen, dem Benutzer oder dem Betreiber des Sicherheitselements anzuzeigen, wann das Sicherheitselement verschlissen ist, sodass rechtzeitig ein Austausch des Sicherheitselements erfolgen kann.

US 6 249 838 B1 offenbart, dass Datenspeicher eine Information enthalten, welche eine verbleibende Laufzeit des Speichers angeben. Dazu wird ein Zähler eingerichtet, der bei jeder Löschoperation einer Speicherzelle um eins erniedrigt wird. Wenn der Zähler den Wert null erreicht, dann können verschiedene Aktionen ergriffen werden, wie z.B. dass eine Warnung an den Benutzer ausgegeben wird oder dass der Speicher gesperrt wird.

Der Erfindung liegt die Aufgabe zugrunde, einen möglichst langen Betrieb eines Sicherheitselements sicherzustellen. Dabei soll die Leistungsfähigkeit des Sicherheitselements nicht eingeschränkt werden. Weiterhin soll der Betreiber des Sicherheitselements über den Betriebszustand des Sicherheitselements informiert sein. Insbesondere sollen sowohl das Sicherheitselement als auch der Betreiber des Sicherheitselements Maßnahmen ergreifen können, um die Betriebszeit wesentlich zu erhöhen. Eine weitere Aufgabe besteht darin, Probleme beim Betrieb des Sicherheitselements zu identifizieren, beispielsweise eine unvorteilhaft programmierte Softwareroutine oder eine fehlerhafte Kommunikationsfähigkeit.

Die Aufgabe der Erfindung wird durch die in den nebengeordneten unabhängigen Patentansprüchen beschriebenen Maßnahmen gelöst. Vorteilhafte Ausgestaltungen sind in den jeweils abhängigen Ansprüchen beschrieben. Insbesondere wird die Aufgabe durch ein Verfahren zum Verlängern der Betriebszeit eines Sicherheitselements aufweisend einen integrierten Halbleiterschaltkreis gelöst. Das Verfahren umfasst die Schritte: Erfassen eines Funktionszustands des integrierten Halbleiterschaltkreises des Sicherheitselements; Bereitstellen eines Datensatz durch das Sicherheitselement für eine entfernte Serverinstanz, wobei der Datensatz den Funktionszustand beinhaltet. Das Verfahren umfasst insbesondere, dass der Funktionszustand die Anzahl von Zugriffsereignissen auf zumindest einen Speicherteilbereich eines nichtflüchtigen Speichers des Sicherheitselements umfasst, wobei die Anzahl mittels einer Zugriffserfassungseinheit des Sicherheitselements erfasst wird und dass die Verwendung des nichtflüchtigen Speichers bei Überschreiten eines vordefinierten Schwellwerts der erfassten Anzahl von Zugriffsereignissen angepasst wird.

Mit diesem Verfahren wird in vorteilhafter Weise erreicht, dass die Serverinstanz über die Anzahl der Zugriffe auf Speicherteilbereiche informiert wird, wodurch rechtzeitig Maßnahmen eingeleitet werden können, um die Betriebszeit des Sicherheitselements zu verlängern und einem ggf. drohenden Ausfall des Sicherheitselements entgegenzuwirken. Die Erfindung hat insbesondere den Vorteil, dass die Serverinstanz Informationen über die Abnutzung des Sicherheitselements erhält. Beispielsweise können damit Fehler bei der Kommunikationsfähigkeit des Sicherheitselements angezeigt werden. Weiterhin können Applikationen und/oder Services des Sicherheitselements detektiert werden, die unvorteilhaft programmiert sind und die Betriebslaufzeit verkürzen würden.

Der Schwellwert ist beispielsweise die garantierte Maximalanzahl an Zugriffen, die vom Hersteller des nichtflüchtigen Speichers für einen Speicherteilbereich garantiert wird, wodurch der entfernten Serverinstanz mitgeteilt wird, dass dieser Speicherteilbereich die garantierte Betriebszeit erreicht hat. Insbesondere ist der vordefinierte Schwellwert ein Bruchteil dieser Maximalanzahl, beispielsweise jedes Zehntel dieser Maximalanzahl, wodurch die entfernte Serverinstanz frühzeitig informiert wird, in welchem Betriebsalter der jeweilige Speicherteilbereich ist.

Unter Anpassen der Verwendung des nichtflüchtigen Speichers wird das Neuverwalten des Speichers, das Ändern der Zugriffsrechte für Speicherteilbereiche und/oder das Umsortieren des nichtflüchtigen Speichers verstanden, also Maßnahmen die zur Verlängerung der Betriebszeit führen. Mit Anpassen der Verwendung ist insbesondere nicht das komplette Sperren des Speichers gemeint, beispielsweise im Rahmen einer Fehlbedienungserkennung oder eines Manipulationsangriffs, da damit die Betriebsfähigkeit des Sicherheitselements zumindest temporär beendet wäre, wohingegen hier die Betriebszeit verlängert wird.

Dabei ist entscheidend, dass die Zugriffserfassungseinheit logisch ein Teil der zentralen Recheneinheit ist, wodurch die Anpassung der Speicherverwendung vom Sicherheitselement beeinflusst werden kann.

Der nichtflüchtige Speicher ist insbesondere ein semi-permanenter Datenspeicher. Das Zugriffsereignis ist dabei insbesondere ein Schreibzugriffsereignis, welches endgeräteseitig, serverseitig und/oder sicherheitselementeseitig initiiert werden kann. Als derartige Zugriffsereignisse werden insbesondere das Erfassen eines RESET des Sicherheitselements, das Erfassen einer fehlgeschlagenen oder erfolgreichen Authentisierung, das Erfassen eines EVENTS, das Erfassen eines Kommandos und/oder das Erfassen einer Datei- oder Variablenaktualisierungen verstanden, die einen Schreibzugriff auf den nichtflüchtigen Speicher bedingen.

Durch das Erfassen dieser Schreibzugriffsereignisse wird ein Großteil der, für das potentiellen Altern des nichtflüchtigen Speichers des Sicherheitselements verantwortlichen, Ereignisse erfasst und an die entfernte Serverinstanz übermittelt.

Bei dem Speicherteilbereich handelt es sich insbesondere um einen Dateisektor oder eine Speicherseite, englisch Page des nichtflüchtigen Speichers, also eine Teileinheit des Speichers. Die maximale Anzahl von Schreibzugriffsereignissen bezieht sich dabei auf einen Speicherteilbereich.

In einer Ausgestaltung umfasst der Datensatz die Anzahl der Schreibzugriffe von mehreren Speicherteilbereichen, wodurch eine umfassende Analyse seitens der Serverinstanz möglich ist.

Der zu übermittelnde Datensatz umfasst dabei in vorteilhafter Weise nicht nur die Anzahl der Zugriffsereignisse des/ der Speicherteilbereich/ e, sondern auch das Ereignis selbst, welches den Zugriff verursacht hat. Der Datensatz umfasst insbesondere eine Kombination aus Anzahl der Zugriffsereignisse und einer Identifizierung des jeweiligen Speicherteilbereichs, sodass häufig beschriebene Speicherteilbereiche im Rahmen einer sogenannten Hotspot-Analyse lokalisiert werden können.

Der zu übermittelnde Datensatz umfasst in einer Ausgestaltung neben der Anzahl der Zugriffsereignisse auch eine Bezeichnung des Ereignisses welches den Zugriff ausgelöst hat.

In einer Ausgestaltung umfasst der Datensatz die Anzahl der Schreibzugriffe von einer Vielzahl von Speicherteilbereichen unter Angabe der in dem Speicherteilbereich enthaltenen häufig zu aktualisierenden Dateien und/ oder Variablen. Dadurch können Applikationen und oder Services des Sicherheitselements detektiert werden, die die Betriebszeit des Sicherheitselements aufgrund der Aktualisierungsrate ihrer dazugehörigen Dateien und/ oder Variablen am meisten verkürzen bzw. am meisten beeinflussen.

In einer vorteilhaften Ausgestaltung wird der Datensatz von dem Sicherheitselement automatisch versendet, sobald das Überschreiten des vordefinierten Schwellwerts erkannt wird. Somit wird ein Automatismus erreicht der sofort und/ oder zeitversetzt den Datensatz an die Serverinstanz übermittelt. Eine Interaktion seitens des Benutzers oder der Serverinstanz ist somit an dieser Stelle nicht notwendig.

In einer alternativen Ausgestaltung wird der Datensatz von der Serverinstanz zur Ermittlung des Funktionszustands des Sicherheitselements angefordert. Die Serverinstanz ist somit in der Lage, jederzeit den Zustand des nichtflüchtigen Speichers abzufragen und einem möglichen Ausfall durch Anpassung der Speicherverwendung entgegen zu wirken.

In einer vorteilhaften Ausgestaltung werden in Abhängigkeit des Datensatzes Applikationen und/oder Dienste auf dem Sicherheitselement angepasst. Stellt die Serverinstanz fest, dass ein spezieller Service oder eine spezielle Applikation den nichtflüchtigen Speicher sehr oft beschreibt, kann dieser deaktiviert werden. Dies erhöht die Betriebszeit des Sicherheitselements enorm.

Alternativ kann die Serverinstanz oder das Sicherheitselement veranlassen, dass spezielle Daten, Dateien, Variablen etc. nicht mehr im nichtflüchtigen Speicher abgelegt werden, sondern beispielsweise nur noch in einem flüchtigen Speicherbereich. Alternativ kann veranlasst werden, dass die Aktualisierungsrate für derartige Daten, Dateien, Variablen etc. verringert wird, indem nur noch ein vordefiniertes Vielfaches der Daten, Dateien, Variablen etc im nichtflüchtigen Speicher abgelegt wird.

In einer vorteilhaften Ausgestaltung ordnet die Zugriffserfassungseinheit die einzelnen Speicherteilbereiche entsprechend eines entsprechenden Zählerstands der erfassten Anzahl von Zugriffsereignissen. Entsprechend der Ordnung können dadurch Datensätze an die Serverinstanz in Abhängigkeit des Zählerstands gesendet werden, wobei beispielsweise nur eine vordefinierte Nummer der höchsten erfassten Anzahlen von Zugriffen auf Speicherteilbereiche im Datensatz an die Serverinstanz übermittelt werden.

In einer bevorzugten Ausgestaltung legt eine Verwaltungseinheit des Sicherheitselements die erfasste Anzahl der Zugriffsereignisse durch Aktualisieren eines Zählerstands in einem exklusiv für den Zählerstand reservierten Speicherteilbereich des nichtflüchtigen Speichers ab. Die Verwaltungseinheit ist wie die Zugriffserfassungseinheit eine Teilkomponente der zentralen Recheneinheit des Halbleiterschaltkreises und damit von einem Flashcontroller zu unterscheiden.

Sicherheitselemente werden oftmals in sogenannten Sessions betrieben, wobei zwischen den einzelnen Sessions möglicherweise keine Versorgung zum Betreiben des Sicherheitselements vorhanden ist. Alle bis dahin erfassten Anzahlen von Zugriffsereignissen werden in der Regel nach einer Session verworfen. Das Ablegen im nichtflüchtigen Speicher hat somit den Vorteil, dass die erfasste Anzahl von Zugriffen in Form von Zählerständen im nichtflüchtigen Speicher abgelegt ist. Der Zählerstand ist dabei eine Zahl entsprechend der erfassten Anzahl der Zugriffe auf den Speicherteilbereich im nichtflüchtigen Speicher. Dieser Zählerstand kann inkrementiert oder dekrementiert werden.

Unter exklusiv für den Zählerstand reservierten Speicherteilbereich wird dabei verstanden, dass in diesen Speicherteilbereich nur der Zählerstand und ansonsten keine zusätzlichen Daten, oder Dateien oder Variablen abgelegt werden. Dadurch wird sichergestellt, dass das häufige Aktualisieren der Zählerstände den nichtflüchtigen Speicher nicht zusätzlich belastet, was sogar zu einer Verkürzung der Betriebszeit führen könnte.

Problematisch ist, dass jede Aktualisierung des Zählerstands im nichtflüchtigen Speicher zusätzlich belastet und ggf. die Betriebszeit verkürzt werden würde. Daher wird der Zählerstand gemäß einer bevorzugten Ausgestaltung durch die Verwaltungseinheit zunächst in einem flüchtigen Speicherbereich des Sicherheitselements abgelegt und nur bei Überschreiten eines vordefinierten Vielfachen des im flüchtigen Speicher abgelegten Zählerstands wird ein Zählerstand im nichtflüchtigen Speicherteilbereich aktualisiert. Das vordefinierte Vielfache kann dabei in Abhängigkeit der garantierten Anzahl von Zugriffen auf einen Speicherteilbereich erfolgen oder ein vordefiniertes ganzzahliges Vielfaches sein.

Um den nichtflüchtigen Speicherbereich nicht zusätzlich durch die Zählerstände zu beanspruchen, wird alternativ ein sogenanntes Zählerstand-Mapping vorgeschlagen. Dabei legt die Verwaltungseinheit mehrere erfasste Anzahlen von Zugriffsereignissen in unterschiedlichen Speicherteilbereichen durch Aktualisieren entsprechender Zählerstände im nichtflüchtigen Speicherbereich ab, wobei ein zu aktualisierender Zählerstand in einem Speicherteilbereich abgelegt wird, der im Vergleich zur Aktualisierungsrate des Zählerstands eine geringere Anzahl von Zugriffsereignissen aufweist. Dadurch werden die höchsten Zählerstände in Speicherteilbereichen mit wesentlich niedrigeren Aktualisierungsraten abgelegt. Es wird weiterhin verhindert, dass ein Speicherteilbereich mit einer vergleichsweise hohen Anzahl von Schreibzugriffen zusätzlich noch einen hohen Zählerstand beinhaltet.

In einer bevorzugten Ausgestaltung verhindert die Verwaltungseinheit des Sicherheitselements ein Zugriffsereignis auf einen Speicherteilbereich, sobald der vordefinierte Schwellwert überschritten ist. Alternativ werden exklusive Zugriffsrechte nur für die Serverinstanz vergeben, sodass der Speicherteilbereich nicht weiter vom Sicherheitselement beschrieben werden kann. Die Betriebszeit wird dadurch weiter gesteigert, da potentiell gefährdete Speicherteilbereiche erkannt und für weitere Schreibzugriffe gesperrt werden. In einer bevorzugten Ausgestaltung erfolgt das Anpassen der Speicherverwendung, indem Daten, Dateien und/ oder Variablen eines vordefinierten Typs in unterschiedliche Speicherteilbereiche abgelegt werden. Insbesondere werden Dateien mit gleichen Attributen, beispielsweise dem Attribut "High Update Activity" gemäß Rankl/Effings "Handbuch der Chipkarten" in der 5. Auflage, auf unterschiedliche Speicherteilbereiche aufgeteilt, wodurch die einzelnen Speicherteilbereich eine längere Betriebszeit aufweisen können. Dabei können diese Dateien auch in noch unbeschriebene Speicherteilbereiche abgelegt werden. Die Anpassung der Speicherverwendung erfolgt insbesondere serverseitig oder mittels der Verwaltungseinheit des Sicherheitselements.

In einer bevorzugten Ausgestaltung erfolgt das Anpassen der Speicherwendung derart, dass ein Datum, eine Datei und/ oder eine Variable in einem vom ursprünglichen Speicherteilbereich verschiedenen Speicherteilbereich abgelegt wird, sobald die erfasste Anzahl von Zugriffsereignissen im ursprünglichen Speicherteilbereich den vordefinierten Schwellwert überschreitet. Es wird also seitens des Sicherheitselements selbst oder seitens der Serverinstanz festgestellt, dass ein Speicherteilbereich seinen Maximalwert erreicht hat, sodass die Daten, Dateien und/ oder Variablen dieses Speicherteilbereichs in einen anderen Teilbereich oder in andere Teilbereiche abgelegt werden.

Alternativ erfolgt das Anpassen der Speicherwendung derart, dass Daten, Dateien und/oder Variablen, die ursprünglich in einem gemeinsamen Speicherteilbereich abgelegt wurden, auf mehrere unterschiedliche Speicherteilbereiche aufgeteilt werden, sobald die erfasste Anzahl von Zugriffsereignissen den vordefinierten Schwellwert übersteigt.

Der Datensatz wird mittels einer, für den Austausch des Datensatzes geeigneten Netzwerkverbindung an die entfernte Serverinstanz übermittelt.

Im Erfindungsgrundgedanken ist weiterhin die Verwendung des Verfahrens in einem Sicherheitselement vorgesehen.

Im Erfindungsgrundgedanken ist weiterhin ein Computerprogrammprodukt vorgesehen, welches zum Ausführen des Verfahrens eingerichtet ist, wobei das Computerprogrammprodukt in einer zentralen Recheneinheit des Sicherheitselements ausgeführt wird.

Im Erfindungsgrundgedanken ist weiterhin ein System bestehend aus zumindest einem Sicherheitselement aufweisend einen integrierten Halbleiterschaltkreis: mit einem nichtflüchtigen Speicher zum Ablegen von Daten; einer zentralen Recheneinheit; und zumindest einer Schnittstelle zum Übermitteln eines Datensatzes betreffend eines Funktionszustands des Sicherheitselements. Das System umfasst weiterhin eine entfernte Serverinstanz, zum Erhalten des Datensatzes und ein Netzwerk, durch das wenigstens temporär eine Datenverbindung zwischen dem Sicherheitselement und der entfernten Serverinstanz ausgebildet wird. Die zentrale Recheneinheit weist eine Zugriffserfassungseinheit zum Erfassen einer Anzahl von Zugriffsereignissen auf Speicherteilbereiche des nichtflüchtigen Speicherbereichs auf. Der Datensatz umfasst die erfasste Anzahl der Zugriffsereignisse. Der nichtflüchtige Speicher ist bei Überschreiten eines vordefinierten Schwellwerts der erfassten Anzahl von Zugriffsereignissen anpassbar.

Das System weist eine Vielzahl von Sicherheitselementen auf, die jeweils mit der entfernten Serverinstanz verbunden sind.

Die entfernte Serverinstanz ist bevorzugt ein Over-the-Air Server in einem Mobilfunknetz. Das Sicherheitselement ist bevorzugt ein Teilnehmeridentifizierungsmodul in einem Endgerät, wobei das Netzwerk ein Mobilfunknetzwerk ist.

Der Datensatz ist in einer bevorzugten Ausgestaltung eine Nachricht des Short Message Service, kurz SMS.

Als Mobilfunknetz wird eine technische Infrastruktur verstanden, auf der die Übertragung von Signalen für den Mobilfunk stattfindet. Darunter ist im Wesentlichen das Mobilvermittlungsnetz, in dem die Übertragung und Vermittlung der Signale zwischen ortsfesten Einrichtungen und Plattformen des Mobilfunknetzes stattfinden, sowie das Zugangsnetz (auch als Luftschnittstelle bezeichnet), in dem die Übertragung der Signale zwischen einer Mobilfunkantenne und einem mobilen Endgerät stattfindet, zu verstehen. Beispielsweise das "Global System for Mobile Communications", kurz GSM als Vertreter der sogenannten zweiten Generation oder das General Packet Radio Service, kurz GPRS und Universal Mobile Telecommunications System, kurz UMTS als Vertreter der sogenannten dritten Generation von Mobilfunknetzen seien hier erwähnt, wobei bei der dritten Generation das Mobilvermittlungsnetz um die Fähigkeit einer paketorientierten Datenübertragung erweitert wird, das Funknetz an sich aber unverändert ist.

Der Übertragung des Datensatzes an die Serverinstanz ist prinzipiell keine Grenze gesetzt. So kann die Übertragung over-the-air, kurz OTA, over-theinternet, kurz OTI, mittels eines lokalen Netzwerkanschlusses, bspw. (W)LAN oder auch über eine Nahfeldkommunikationsschnittstelle erfolgen.

Zur Übertragung des Datensatzes wird beispielsweise das Bearer Independent Protocol, kurz BIP verwendet. Alternativ kann das Internet Protokoll, kurz IP, verwendet werden, insbesondere bei einer Übertragung via Long Term Evolution, kurz LTE.

Nachfolgend werden anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein.

Es zeigen:
- Figur 1: Ein skizziertes erfindungsgemäßes System aus Sicherheitselement und entferntem Server
- Figur 2: den Aufbau eines erfindungsgemäßen Sicherheitselements
- Figur 3: den Aufbau eines erfindungsgemäßen Sicherheitselements, alternativ zu Figur 2
- Figur 4: den Aufbau eines erfindungsgemäßen Sicherheitselements, alternativ zu Figur 2 und 3
- Figur 5: eine Zugriffserfassungseinheit und Verwaltungseinheit beim Erfassen eines Zugriffsereignisses gemäß der Erfindung
- Figur 6: ein Ausschnitt aus einem erfindungsgemäßen nichtflüchtigen Speicher eines Sicherheitselements
- Figur 7: ein erfindungsgemäßes Anpassen der Speicherverwendung
- Figur 8: ein erfindungsgemäßes Anpassen der Speicherverwendung, alternativ zu Figur 7
- Figur 9: ein erfindungsgemäßes Anpassen der Speicherverwendung, alternativ zu Figuren 7 und 8
- Figur 10: ein erfindungsgemäßer Verfahrensablauf in dem Sicherheitselement zum Anpassen der Speicherverwendung
- Figur 11: ein erfindungsgemäßer Verfahrensablauf in der Serverinstanz zum Anpassen der Speicherverwendung

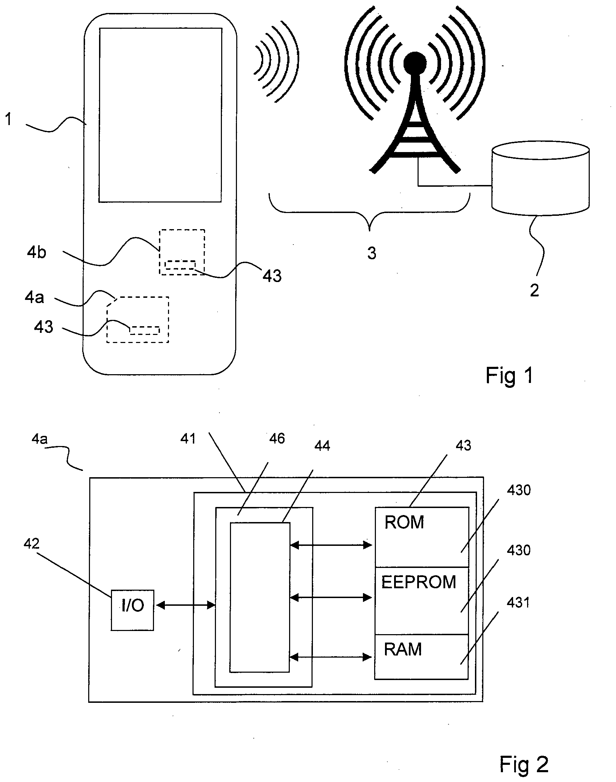

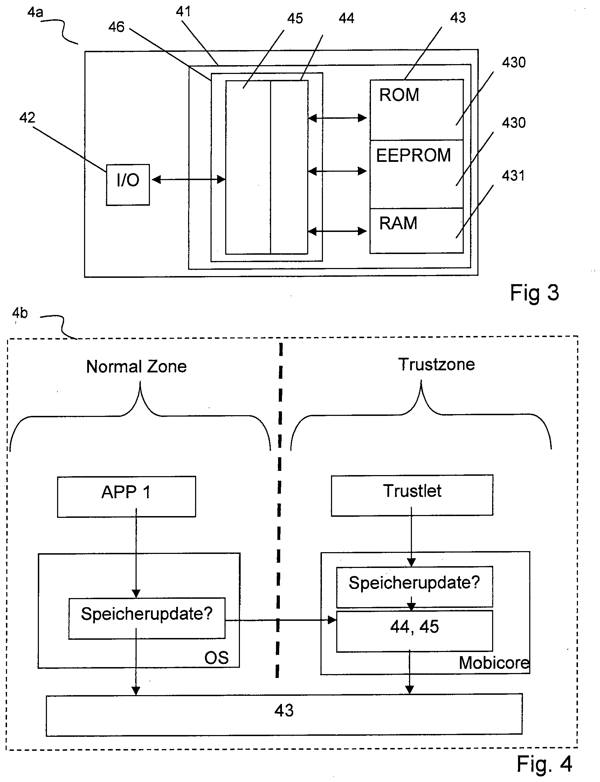

Figur 1 zeigt ein erfindungsgemäßes System bestehend aus einer entfernten Serverinstanz 2 und einem Sicherheitselement. Das Sicherheitselement ist hier einerseits als Hardware-Sicherheitselement 4a mit einem Datenspeicher 43 in ein Endgerät 1 eingebracht. Das Sicherheitselement 4a ist dabei entweder ein SIM oder ein M2M Modul als integrierter Bestandteil des Endgeräts 1. Ein detaillierter Aufbau des Sicherheitselements 4a kann insbesondere den Figuren 2 und 3 entnommen werden. Alternativ oder zusätzlich ist ein Sicherheitselement in Form eines Software-Sicherheitselements 4b mit einem Datenspeicher 43 in das Endgerät 1 eingebracht. Ein detaillierter Aufbau des Sicherheitselements 4b kann insbesondere der Figur 4 entnommen werden.

Die entfernte Serverinstanz 2 ist ein über das Mobilfunknetz 3 mit dem Sicherheitselement zumindest temporär in Kommunikationsverbindung stehender OTA Server. Der OTA Server wird beispielsweise gemäß GSM 03.40, GSM 03.48 und/oder ETSI/SCP - 3GPP - 3GPP2 Standard betrieben. Er empfängt, einen vom Sicherheitselement bereitgestellten Datensatz in Form von SMS. Der Datensatz beinhaltet eine Anzahl von Zugriffsereignissen 5 auf Speicherteilbereiche 4310 des Sicherheitselements.

In Figur 2 ist ein Hardware-Sicherheitselement 4a als Blockschaltbild mit funktionellen Elementen dargestellt. In Figur 2 handelt es sich um ein Teilnehmeridentifizierungsmodul, kurz SIM, das in Form einer Chipkarte in das Endgerät 1 entnehmbar eingesteckt wird. Mittels des SIM 4a authentisiert sich der Teilnehmer an dem Mobilfunknetz 2. Das SIM 4a verfügt dazu über eine Schnittstelle 42, um mit dem Endgerät 1 und/oder den Instanzen des Mobilfunknetzes 2 Daten austauschen zu können. Eine derartige Schnittstelle ist kontaktbehaftet und insbesondere nach dem Standard ISO/IEC 7816 ausgestaltet. Die Ausgestaltung der Schnittstelle 42 kann darüber hinaus auch nach alternativen Standards, beispielsweise USB oder einem Nahfeldkommunikationsstandard, beispielsweise SWP, erfolgen.

In der SIM 4a ist ein integrierter Halbleiterschaltkreis 41 eingebracht. Der Halbleiterschaltkreis umfasst eine zentrale Recheneinheit 46, kurz CPU mit einer darin ausgebildeten Zugriffserfassungseinheit 44. Der Halbleiterschaltkreis 41 umfasst weiterhin einen Datenspeicher 43, der aus einem flüchtigen Speicher 430, engl. Random-Access-Memory, kurz RAM und einem nichtflüchtigen Speicher 431 besteht. Im Folgenden wird nur derjenige nichtflüchtige Speicher 431 betrachtet, der semi-permanent ist, also ein EEPROM, ein Flashspeicher, ein FRAM bzw. FeRAM-Speicher oder MRAM-Speicher. Dieser nichtflüchtige Speicher kann per se nicht unendlich oft beschrieben oder ausgelesen werden. Typischerweise garantiert ein Hersteller eines EEPROM Speichers zwischen 100 000 und 500 000 Schreibzyklen pro Speicherteilbereich 4310, bei einem Flashspeicher werden nur bis zu 100 000 Schreibzyklen pro Speicherteilbereich 4310 garantiert.

Bei Sicherheitselementen ist die typische Größe des nichtflüchtigen Speichers 431 zwischen wenigen Kilobyte bis zu wenigen Megabyte. Der Speicher ist dabei in Speicherteilbereiche 4310 unterteilt, wobei die Teilbereiche 4310 als Speichersektor oder Speicherseite, engl. Page, bezeichnet werden. Die Größe der Speicherteilbereich 4310 variiert in Abhängigkeit der Speichertechnologie. Bei Flashspeichern beträgt die Größe der Speicherteilbereiche zwischen 32 Byte bis 256 Byte, typischerweise 128 Byte. Sicherheitselemente mit Datenspeichern 43 in Größenordnungen von mehreren Megabyte können auch Speicherteilbereiche 4310 von bis zu 64 Kilobyte aufweisen.

Daher ist die Lebenszeit des Sicherheitselements 4a stark abhängig von der Anzahl der Zugriffe auf diesen Speicherbereich 431. Erfindungsgemäß ist daher vorgesehen, die Zugriffe auf die einzelnen Speicherteilbereiche 4310 zu erfassen, um Aussagen über den Verbrauch des Sicherheitselements machen zu können und die Verwendung des Speicherbereichs 431 anzupassen, sobald ein Schwellwert an Zugriffsereignissen eines Speicherteilbereichs 4310 überschritten ist. Dazu ist im Sicherheitselement 4a eine Zugriffsanalyseeinheit 44 vorgesehen, die Schreibzugriffsereignisse 5 auf die einzelnen Speicherteilbereiche 4310 erfasst und protokolliert.

Im Folgenden wird eine Auswahl an Zugriffsereignissen 5 aufgelistet, die von der Zugriffserfassungseinheit 44 erfasst werden:
- Kommandos gemäß SIM Toolkit Applikation, beispielsweise "AUTHENTICATE", "UPDATEFILE", "ENVELOPE", "REFRESH", "RESET"
- EVENTS einer Java Card API, gemäß der JAVA Card SIM API GSM 03.19 oder USIM API für JAVA CARD 3GPP TS 31.130 oder UICC API für Java Card gemäß ETSI TS 102.241
- Aktualisierungen von Variablen Var 1 einer Applikation APP 1 auf dem Sicherheitselement 4a
- Aktualisierungen spezieller Elementary Files EF auf dem Sicherheitselement 4a, beispielsweise EF_Loci; EF_PLMN
- Aktualisierungen eines Fehlbedienungszählers

Die Zugriffserfassungseinheit erfasst die Anzahl derartiger Zugriffe 5 pro Speicherteilbereich 4310. Bei Überschreiten von vordefinierten Schwellwerten X, beispielsweise Bruchteile der garantierten Maximalanzahl (10%, 50%, 80%) der Zugriffe 5 oder bei einer absoluten Schwelle X, beispielsweise X=5000 Zugriffe pro Speicherteilbereich 4310 wird ein Datensatz bereitgestellt und über die Schnittstelle 42 und das Netzwerk 3 dem OTA Server 2 zur Verfügung gestellt.

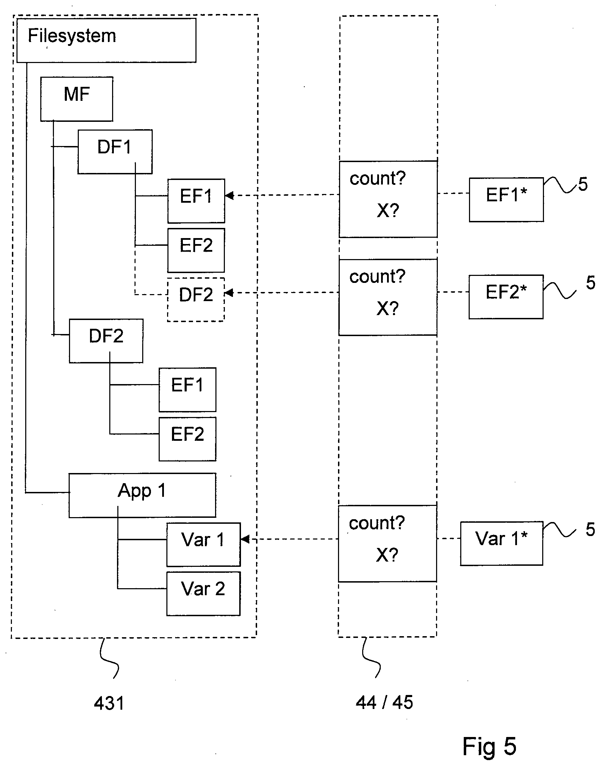

Das Hardware-Sicherheitselement 4a hat in einer nicht dargestellten Ausführung sowohl eine kontaktbehaftete Schnittstelle 42 als auch eine kontaktlose Schnittstelle. Das Betriebssystem des Hardware-Sicherheitselements 4a ist dabei so ausgelegt, dass die kontaktlose Schnittstelle beispielsweise gemäß einer der ISO/IEC 14443,15693 oder 18092 und das kontaktbehaftete Interface beispielsweise gemäß ISO/IEC 7816 parallel bedient werden können. Gemäß Figur 3 ist eine alternative Ausführung eines Hardwaresicherheitsmoduls 4a gezeigt. Hierbei ist im einzigen Unterschied weiterhin eine Verwaltungseinheit 45 vorgesehen, um die Verwendung des Speichers anzupassen, sobald ein Schwellwert X der erfassten Anzahl überschritten ist. Einzelheiten zur Arbeitsweise der Verwaltungseinheit 45 können den Figuren 5-9 entnommen werden.

Sowohl die Zugriffserfassungseinheit 44 als auch die Verwaltungseinheit 45 werden als Teilkomponente in der zentralen Recheneinheit 46 CPU eingebracht und laufen dort beispielsweise als Softwareroutinen ab. Neben der Zugriffserfassungseinheit 44 und der Verwaltungseinheit 45 können weitere Wear-Leveling Mechanismen direkt auf dem Speicherbereich 43 integriert sein.

In Figur 4 ist eine alternative Ausführung eines Sicherheitselements in Form einer Software-Sicherheitselement 4b dargestellt. Prinzipiell unterscheiden sich die Sicherheitselemente 4a der Figuren 2 und 3 von dem Sicherheitselement der Figur 4 in ihrer physischen Ausgestaltung. In Figur 4 wird das Sicherheitselement als Teilkomponente eines Betriebssystemkernels in das Endgerät 1 eingebracht, wobei eine unsichere Betriebssystemkomponente OS und eine gesicherte Laufzeitumgebung, bspw. MobiCore vorgesehen sind. Wann immer eine Applikation App1 oder ein sicheres Trustlet den Speicherbereich 43 beschreiben wollen, erfasst dies eine Routine in der gesicherten Laufzeitumgebung mittels einer Zugriffserfassungseinheit 44 und passt ggf. den Speicher 43, insbesondere den nichtflüchtigen Speicher 431 mittels Verwaltungseinheit 45 an. Sobald ein Schwellwert X erreicht ist, wird der entfernten Serverinstanz 2 ein Datensatz beinhaltend die Anzahl der Zugriffe 5 bereitgestellt.

In Figur 5 ist die Belegung eines Speicherbereichs 431 des Sicherheitselements 4a, 4b der vorangegangen Figuren 2 bis 4 dargestellt. Das beispielhafte Dateisystem ist mit einem Masterfile MF und diversen Directory Files DF beinhaltend mehrere DF oder Elementary Files EF ausgestattet. Weiterhin ist eine Applikation APP 1 mit beispielhaften Variablen Var 1 und Var 2 im Dateisystem enthalten. Werden im Zuge des Betriebs des Sicherheitselements 4a, 4b Zugriffe 5 auf dieses Dateisystem nötig, so wird dies durch die Zugriffserfassungseinheit 44 erfasst. Beispielsweise soll EF1* die abgelegte EF1 ersetzen, wird dies als Zugriff 5 erfasst. Bevorzugt werden Zugriffe auf häufig zu aktualisierende Dateien, beispielsweise die EF_Loci, EF_PLMN, EF_Kc, EF_SMSS, EF_BCCH erfasst. Alternativ können auch Programmroutinen, die eine spezielle Variable Var 1 oft überschreiben erfasst werden.

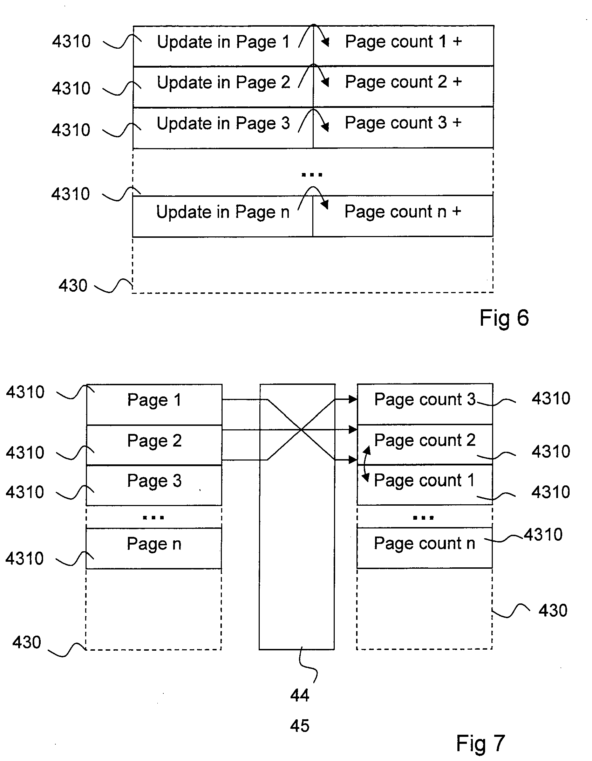

In der Figur 6 wird nun gezeigt, wie ein erfasster Zugriff 5 innerhalb des Sicherheitselements 4a, 4b weiter bearbeitet wird. Dargestellt sind mehrere Speicherteilbereiche 4310 eines nichtflüchtigen Speichers 431, beispielsweise eines EEPROM Speichers. Wird in einem Speicherteilbereich 4310 ein Zugriff 5 erfasst, so wird dies anhand der Aktualisierung eines entsprechenden Zählerstands 6 des jeweiligen Speicherteilbereichs 4310 festgehalten.

Der Zählerstand 6 wird in unterschiedlichen Ausführungen aktualisiert. Die Aktualisierung wird entweder von der Zugriffserfassungseinheit 44 oder der Verwaltungseinheit 45 durchgeführt. Wenn ein Sicherheitselement dauerhaft mit Spannung versorgt wird, so ist es möglich, den Zählerstand 7 in einem flüchtigen Speicher 430 abzulegen und dort zu aktualisieren. Wird ein Schwellwert X überschritten, erfolgt die Bereitstellung des Datensatzes an die entfernte Serverinstanz 2. Wird die Stromversorgung unterbrochen, so verfallen alle bis dahin erfassten Zählerstände 7. Somit sollte der Zählerstand 6 in einem nichtflüchtigen Speicher 431 abgelegt werden. Dabei kann jeder Zugriff 5 auf einen Speicherteilbereich 4310 zu einer Aktualisierung des Zählerstands 6 durch dessen Inkrementierung oder Dekrementierung führen. Dadurch würde der Speicherbereich 431 aber zusätzlich belastet werden, da quasi jeder Zugriff 5 doppelt erfolgt.

Somit sind folgende verschiedene Aktualisierungen des Zählerstands 6 zu bevorzugen:
a) Zunächst erfolgt eine Aktualisierung des Zählerstands 7 im RAM 430 des Sicherheitselements. Jedes vordefinierte Vielfache, beispielsweise 10, 100 etc. dieser Aktualisierung des Zählerstands 7 führt zu einer Aktualisierung eines Zählerstands 7 im nichtflüchtigen Speicher 431 des Sicherheitselements. Das vordefinierte Vielfache ist dann so zu wählen, dass zumindest die Hälfte der erfassten Zugriffe 5 auch nach dem Ende einer Session des Sicherheitselements nachvollzogen werden können.
b) Zunächst erfolgt eine Aktualisierung des Zählerstands 7 im RAM 430 des Sicherheitselements. Zum Ende einer Session werden die entsprechenden Zählerstände 7 durch einmaligen Zugriff 5 auf Zählerstände 6 im nichtflüchtigen Speicher 431 aktualisiert.
c) Ein Zählerstand 6 wird in exklusiv für diesen Zählerstand 6 reservierten Speicherteilbereich 4310 aktualisiert. Somit wird dieser Speicherteilbereich 4310 nur von dem Zählerstand 6 gestresst. Alternativ befinden sich in diesem Speicherteilbereich 4310 nur Daten, Dateien und/oder Variablen, die nicht oder mit einer wesentlich geringeren Häufigkeit als der Zählerstand 6 selbst.

Somit können Datensätze vom Sicherheitselement bereitgestellt werden, in denen die aktualisierten Zählerstände 6 einzelner, mehrerer oder aller Speicherteilbereiche 4310 eingebracht werden. Die entfernte Serverinstanz 2 ist somit informiert darüber, welche Speicherteilbereiche 4310 besonders häufigen Zugriffen 5 unterliegen und kann ggf. auf ein Fehlverhalten des Sicherheitselements, einer Applikation App1 oder eine hohe Ausfallrate des Netzes 3 rückschließen.

In Figur 7 ist das Erfassen der Zugriffe 5 und das entsprechende Aktualisieren von Zählerständen 6 anhand eines Zählerstände-Mapping gezeigt. Dabei werden Zählerstände 6, die aufgrund häufig erfasster Zugriffe 5 auch häufig aktualisiert werden müssen, in Speicherteilbereiche 4310 abgelegt, die wesentlich weniger häufig aktualisiert werden müssen. Dieses Mapping wird von der Verwaltungseinheit 45 durchgeführt. Wird nun festgestellt, dass ein Zählerstand 6 doch häufiger aktualisiert wird, als entsprechend seiner ersten Annahme, so wird der Zählerstand 6 von seinem ursprünglichen Speicherteilbereich 4310 in einen alternativen Speicherteilbereich 4310 verschoben. Dabei können Zählerstände 6 auch getauscht werden. Somit werden Zählerstände 6 nicht fix an einen Speicherteilbereich 4310 gebunden, sondern können flexibel an unterschiedlichen Speicherteilbereichen 4310 verwendet werden, und passen sich daher der Betriebszeit des Sicherheitselements an. Die Betriebszeit des Sicherheitselements wird damit nicht verkürzt und die entfernte Serverinstanz 2 wird sehr zuverlässig über das Betriebsalter informiert, um ggf. Speicherverwendungen anzupassen.

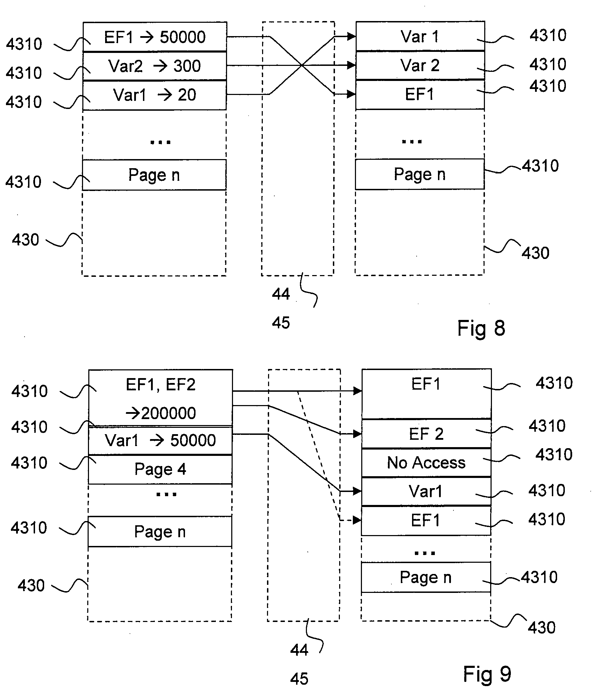

In Figur 8 ist eine alternative Ausführung zur Anpassung der Speicherverwendung gezeigt. Wird im Server 2 oder in der Verwaltungseinheit 45 erkannt, dass eine Datei EF1 sehr häufig beschrieben wird, sodass bezüglich der Datei EF1 eine vergleichsweise hohe erfasste Anzahl von Zugriffen 5 erkannt wurde, beispielsweise 50000, so wird diese Datei EF1 mittels der Verwaltungseinheit 45 oder auf Basis eines OTA Serverbefehls, in einen Speicherteilbereich 4310 verschoben, der eine geringere Anzahl von Schreibzugriffen 5 aufweist, hier gemäß eines Vertauschens des Speicherteilbereichs 4310 von Var 1 mit 20 Aktualisierungen und EF1 mit 50000 Aktualisierungen. Dies kann sehr dynamisch erfolgen, sodass erreicht wird, dass die Speicherteilbereiche 4310 annähernd gleich beschrieben werden. Somit wird der Speicher 431 gleichmäßiger abgenutzt, sogenannte Hot-Spots werden vermieden.

In Figur 9 wird eine alternative Ausführung zur Anpassung der Speicherverwendung gezeigt. In Figur 9 sind verschiedene Anpassungen beschrieben, die getrennt voneinander zu betrachten sind. In einem Speicherteilbereich 4310 sind zwei Dateien EF1, EF2 abgelegt. Die erfasste Anzahl von Zugriffen 5 auf diesen Speicherteilbereich hat einen Schwellwert X erreicht. Die Verwaltungseinheit 45 oder der Server 2 verschieben entweder eine der beiden Dateien in einen anderen Speicherteilbereich 4310 oder Sperren den Speicherteilbereich 4310 und verschieben beide Dateien in alternative Speicherteilbereiche 4310, siehe gestrichelte Linie. Das Anpassen umfasst somit auch das Verhindern von Schreibzugriffen auf Speicherteilbereiche, um die Betriebszeit des Sicherheitselements zu verlängern. Dies ist durch "No Access" in Fig. 9 dargestellt.

Alternativ kann eine Variable Var 1 eines Speicherteilbereichs 4310 bei Überschreiten eines Schwellwertes X in einen weniger oft beschriebenen Speicherteilbereich 4310 verschoben werden.

Weiterhin wird erkannt, wenn eine Datei EF sehr häufig geschrieben wird. Der Server 2 kann feststellen, inwieweit dieser häufige Schreibzugriff gerechtfertigt ist, oder ob unverhältnismäßig viele Zugriffe 5 auf diese Datei erfolgten. Es können somit Fehlerfälle erkannt werden, insbesondere:
a) Werden Authentisierungen sehr oft durchgeführt, so kann dies an Problemen in Verbindung mit dem Einbuchen in das Netzwerk 3 aufgrund von Netzüberlastung, fehlender Netzabdeckung, fehlerhafter Antennenverbindung oder dergleichen liegen.
b) Werden Dateien oder Variablen sehr oft beschrieben, kann dies an einem Angriff auf Sicherheitsbereiche liegen, sodass der Server ggf. das Sicherheitselement sperrt, um vertrauenswürdige Informationen zu schützen.
c) Werden Dateien oder Variablen sehr oft beschrieben, kann dies an einer falschen Softwareroutine liegen, beispielsweise eine nachgeladene Applikation, die unverhältnismäßig oft in einen Speicherteilbereich 4310 schreiben möchte kann serverseitig gesperrt werden.

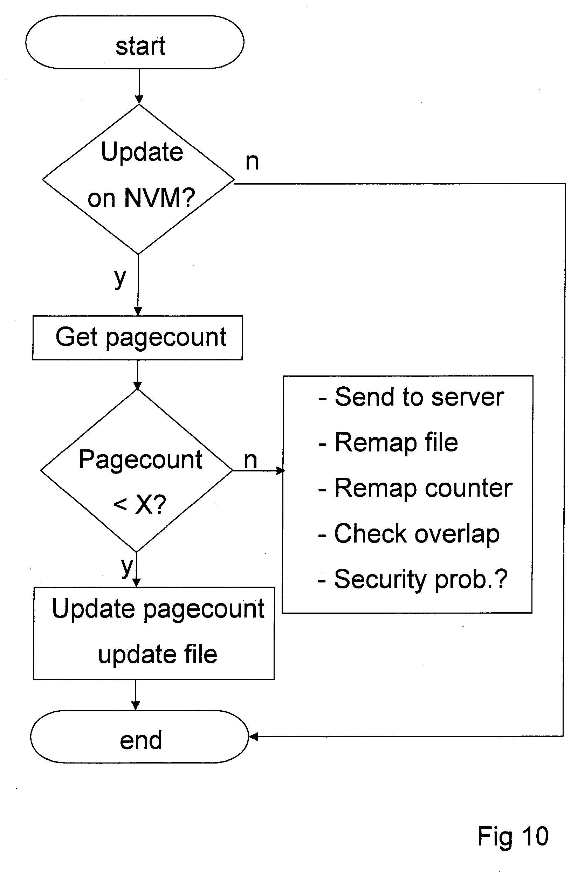

In Figur 10 ist ein Verfahrensablauf skizziert, wie er in einem erfindungsgemäßen Sicherheitselement 4a, 4b stattfindet. Zunächst wird ein Schreibzugriffsereignis 5 in einem Speicherteilbereich 4310 erfasst. Zu diesem Speicherteilbereich 4310 wird nun der Zählerstand 6, 7 abgefragt und geprüft, ob der Zählerstand 6,7 einen Schwellwert X überschreitet oder nicht. Ergibt die Prüfung, dass der Schwellwert X überschritten wurde, werden eine oder mehrere der folgenden Maßnahmen ausgelöst:
- Datensatz erstellen und an Serverinstanz 2 versenden
- die zu überschreibende Datei wird in einen anderen Speicherteilbereich verschoben;
- der Zählerstand 6 zu diesem Speicherteilbereich 4310 wird verschoben
- Sind mehrere kritische Dateien in einem Speicherteilbereich 4310 abgelegt
- Liegt ein Angriff auf sicherheitsrelevante Daten vor und müssen ggf. Sicherheitsmaßnahmen ergriffen werden?

Ergibt die Prüfung, dass der Schwellwert X nicht überschritten wurde, so erfolgt das Aktualisieren des Zählerstands 6 oder 7 und das Überschreiben der Datei, Variable etc. Das Verfahren ist danach beendet.

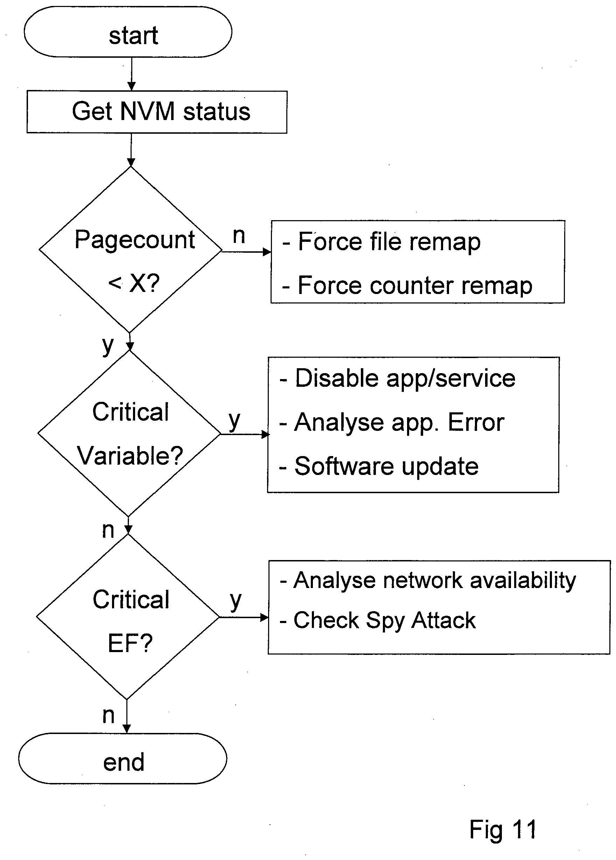

In Figur 11 ist ein Verfahrensablauf skizziert, wie er in einer erfindungsgemäßen Serverinstanz 2 stattfindet. Dazu wird seitens des Servers der Status des nichtflüchtigen Speichers eines Sicherheitselements 4a, 4b abgefragt. Dies erfolgt gemäß einem PUSH-PULL Mechanismus, indem der Server 2 die im Sicherheitselement 4a, 4b bereitgestellten Daten abruft, um zu erfahren, wie der Speicher des Sicherheitselements beschaffen ist. In der Serverinstanz 2 erfolgt die Überprüfung ob eine erfasste Anzahl von Speicherzugriffen 5 einen vordefinierten Schwellwert überschritten hat. Ergibt die Prüfung, dass der Schwellwert X überschritten wurde, so wird ein Zählerstand-Mapping und/oder ein Dateiverschieben initiiert. Dazu werden entweder OTA Serverbefehle generiert oder die Verwaltungseinheit 45 in dem Sicherheitselement informiert, die Datei zu verschieben.

Ergibt die Prüfung, dass der Schwellwert X nicht überschritten wurde, folgt ggf. eine Prüfung darauf, ob eine sehr häufig aktualisierte Variable Var1 im Datensatz identifiziert ist. Ergibt die Prüfung, dass eine kritische Variable Var1 im Datensatz identifiziert wurde, so veranlasst die Serverinstanz den Stopp des zur Variable Var1 zugehörigen Dienstes oder Applikation. Weiterhin erfolgt eine Überprüfung der zugehörigen Applikation auf fehlerhafte Programmierung und ob ein Software-Update möglich ist.

Ergibt die Prüfung, dass keine kritische Variable Var1 im Datensatz identifiziert wurde, folgt ggf. eine Prüfung darauf, ob eine häufig zu aktualisierende Datei EF identifiziert wurde. Ergibt die Prüfung, dass eine Datei EF identifiziert wurde, so veranlasst die Serverinstanz eine Analyse der Netzwerkverbindung und ob ein Angriff auf sicherheitskritische Daten stattgefunden haben könnte.

Die Serverinstanz hat durch das erfindungsgemäße Verfahren einerseits die Möglichkeit, die Sicherheitselemente auf ihren Alterzustand hin abzufragen, kann weiterhin Maßnahmen zur Verlängerung der Betriebszeit anstoßen und erfährt, ob bestimmte Sicherheitselemente einem besonderen Stress ausgesetzt sind.

### Bezugszeichenliste

1 Endgerät
2 Serverinstanz, OTA, OTI
3 Netzwerk, Mobilfunk, LAN, WLAN
   4a Hardware -Sicherheitselement, TPM, SIM, M2M
   4b Software-Sicherheitselement, TEE
   41 Integrierter Halbleiterschaltkreis
   42 Schnittstelle
   43 Datenspeicher
      430 Flüchtiger Speicher, RAM
      431 Nichtflüchtiger Speicher, ROM, EEPROM, Flash
         4310 Speicherteilbereich, Sektor, Page
   44 Zugriffserfassungseinheit
   45 Verwaltungseinheit
   46 Zentrale Recheneinheit, CPU
5 Zugriffsereignis
6 Zählerstand im nichtflüchtigen Speicher
7 Zählerstand im flüchtigen Speicher
App1 Applikation auf dem Sicherheitselement
EF Datei auf dem Sicherheitselement
EF* zu aktualisierende Datei
Page x Speicherteilbereich x
Page count x Zählerstand der Zugriffe auf Speicherteilbereich x
Var Variable einer Applikation
X Schwellwert

## Patentansprüche

1. Verfahren zum Verlängern der Betriebszeit eines Sicherheitselements (4a, 4b) aufweisend einen integrierten Halbleiterschaltkreis (41) mit den Verfahrensschritten:
- Erfassen eines Funktionszustands des integrierten Halbleiterschaltkreises (41) des Sicherheitselements (4a, 4b);
- Bereitstellen eines Datensatz durch das Sicherheitselement (4a, 4b) für eine entfernte Serverinstanz (2), wobei der Datensatz den Funktionszustand beinhaltet;
- wobei der Funktionszustand die Anzahl von Zugriffsereignissen (5) auf zumindest einen Speicherteilbereich (4310) eines nichtflüchtigen Speichers (431) des Sicherheitselements (4a, 4b) umfasst, wobei die Anzahl mittels einer Zugriffserfassungseinheit (44) des Sicherheitselements (4a, 4b) erfasst wird; und
- wobei die Verwendung des nichtflüchtigen Speicher (431) bei Überschreiten eines vordefinierten Schwellwerts (X) der erfassten Anzahl von Zugriffsereignissen (5) angepasst wird,
- wobei das Zugriffsereignis (5) ein Schreibzugriffsereignis ist und das Schreibzugriffsereignis endgeräteseitig, serverseitig und/ oder sicherheitselementeseitig initiiert wird,
- wobei der Datensatz von dem Sicherheitselement (4a, 4b) automatisch versendet wird, sobald das Überschreiten des vordefinierten Schwellwerts (X) erkannt wird,
**dadurch gekennzeichnet, dass**
der Datensatz von der Serverinstanz (2) zur Ermittlung des Funktionszustands des Sicherheitselements (4a, 4b) angefordert wird,
wobei in Abhängigkeit des Datensatzes Applikationen (Appl) und/oder Dienste auf dem Sicherheitselement (4a, 4b) angepasst werden.

2. Verfahren nach einem der vorhergehenden Ansprüche, **dadurch gekennzeichnet, dass** die Zugriffserfassungseinheit die einzelnen Speicherteilbereiche (4310) entsprechend eines entsprechenden Zählerstands (6) der erfassten Anzahl von Zugriffsereignissen (5) ordnet.

3. Verfahren nach einem der vorhergehenden Ansprüche, **dadurch gekennzeichnet, dass** eine Verwaltungseinheit (45) des Sicherheitselements (4a, 4b) die erfasste Anzahl der Zugriffsereignisse (5) durch Aktualisieren eines Zählerstands (6) in einem exklusiv für den Zählerstand (6) reservierten Speicherteilbereich (4310) des nichtflüchtigen Speichers (431) ablegt.

4. Verfahren nach einem der vorhergehenden Ansprüche, **dadurch gekennzeichnet, dass** eine Verwaltungseinheit (45) des Sicherheitselements (4a, 4b) die erfasste Anzahl der Zugriffsereignisse (5) durch Aktualisieren eines Zählerstands (7) zunächst in einem flüchtigen Speicherbereich (430) des Sicherheitselements (4a, 4b) ablegt und nur bei Überschreiten eines vordefinierten Vielfachen des im flüchtigen Speichers (430) abgelegten Zählerstands (7) ein Zählerstand (6) im nichtflüchtigen Speicherteilbereich (4310) aktualisiert wird.

5. Verfahren nach einem der vorhergehenden Ansprüche, **dadurch gekennzeichnet, dass**
- eine Verwaltungseinheit (45) des Sicherheitselements (4a, 4b) mehrere erfasste Anzahlen von Zugriffsereignissen (5) in unterschiedlichen Speicherteilbereichen (4310) durch Aktualisieren entsprechender Zählerstände (6) im nichtflüchtigen Speicherbereich (431) ablegt und
- die Verwaltungseinheit (45) einen zu aktualisierenden Zählerstand (6) in einem Speicherteilbereich (4310) ablegt, der im Vergleich zur Aktualisierungsrate des Zählerstands (6) eine geringere Anzahl von Zugriffsereignissen (5) aufweist.

6. Verfahren nach einem der vorhergehenden Ansprüche, **dadurch gekennzeichnet, dass** eine Verwaltungseinheit (45) des Sicherheitselements (4a, 4b) und/oder die entfernte Serverinstanz (2) ein Zugriffsereignis (5) auf einen Speicherteilbereich (4310) verhindert, sobald der vordefinierte Schwellwert (X) überschritten ist.

7. Verfahren nach einem der vorhergehenden Ansprüche, **dadurch gekennzeichnet, dass** das Anpassen der Speicherwendung erfolgt, indem Dateien (EF) und/oder Variablen (Var) eines vordefinierten Typs in unterschiedliche Speicherteilbereiche (4310) abgelegt werden.

8. Verfahren nach einem der vorhergehenden Ansprüche, **dadurch gekennzeichnet, dass** das Anpassen der Speicherwendung derart erfolgt, dass eine Datei (EF) und/oder eine Variable (Var) in einem vom ursprünglichen Speicherteilbereich (4310) verschiedenen Speicherteilbereich (4310) abgelegt wird, sobald die erfasste Anzahl von Zugriffsereignissen (5) im ursprünglichen Speicherteilbereich (4310) den vordefinierten Schwellwert (X) überschreitet.

9. Verfahren nach einem der vorhergehenden Ansprüche, **dadurch gekennzeichnet, dass** das Anpassen der Speicherwendung derart erfolgt, dass Dateien (EF) und/oder Variablen (Var), die ursprünglich in einem gemeinsamen Speicherteilbereich (4310) abgelegt wurden, auf mehrere unterschiedliche Speicherteilbereiche (4310) aufgeteilt werden, sobald die erfasste Anzahl von Zugriffsereignissen (5) den vordefinierter Schwellwert (X) übersteigt.

10. Verfahren nach einem der vorhergehenden Ansprüche, **dadurch gekennzeichnet, dass** der Datensatz mittels einer, für den Austausch des Datensatzes geeigneten Netzwerkverbindung (3) an die entfernte Serverinstanz (2) übermittelt wird.

11. System umfassend:
- zumindest ein Sicherheitselement (4a, 4b) aufweisend einen integrierten Halbleiterschaltkreis (41) :
- mit einem nichtflüchtigen Speicher (431) zum Ablegen von Daten;
- mit einer zentralen Recheneinheit (46); und
- mit zumindest einer Schnittstelle (42) zum Übermitteln eines Datensatzes betreffend eines Funktionszustands des Sicherheitselements (4);
- wobei die zentrale Recheneinheit (46) eine Zugriffserfassungseinheit (44) zum Erfassen einer Anzahl von Zugriffsereignissen (5) auf Speicherteilbereiche (4310) des nichtflüchtigen Speicherbereichs (431) aufweist;
- wobei der Datensatz die erfasste Anzahl der Zugriffsereignisse (5) umfasst; und
- wobei der nichtflüchtige Speicher (431) bei Überschreiten eines vordefinierten Schwellwerts (X) der erfassten Anzahl von Zugriffsereignissen (5) anpassbar ist;
- und umfassend eine entfernte Serverinstanz (2), zum Erhalten des Datensatzes; und
- und umfassend ein Netzwerk (3), durch das wenigstens temporär eine Datenverbindung zwischen dem Sicherheitselement (4) und der entfernten Serverinstanz (2) ausgebildet wird,
- wobei das Zugriffsereignis (5) ein Schreibzugriffsereignis ist und das Schreibzugriffsereignis endgeräteseitig, serverseitig und/ oder sicherheitselementeseitig initiierbar ist,
- wobei das Sicherheitselement (4a, 4b) ausgebildet ist, den Datensatz automatisch zu versenden, sobald das Überschreiten des vordefinierten Schwellwerts (X) erkannt wird,
**dadurch gekennzeichnet, dass:**
der Datensatz von der Serverinstanz (2) zur Ermittlung des Funktionszustands des Sicherheitselements (4a, 4b) anforderbar ist,
wobei die Serverinstanz ausgebildet ist, Applikationen (Appl) und/oder Dienste auf dem Sicherheitselement (4a, 4b) in Abhängigkeit des Datensatzes anzupassen.

## Claims

1. A method for extending the operating time of a security element (4a, 4b) having an integrated semiconductor circuit (41) with the method steps of:
- detecting a functional state of the integrated semiconductor circuit (41) of the security element (4a, 4b);
- supplying a data set by the security element (4a, 4b) for a remote server entity (2), wherein the data set includes the functional state;
- wherein the functional state comprises the number of access events (5) to at least one memory subregion (4310) of a nonvolatile memory (431) of the security element (4a, 4b), wherein the number is detected by an access detection unit (44) of the security element (4a, 4b); and
- wherein the use of the nonvolatile memory (431) is adapted when a predefined threshold value (X) of the detected number of access events (5) is exceeded,
- wherein the access event (5) is a write access event and the write access event is initiated on the terminal side, server side and/or security element side,
- wherein the data set is automatically sent by the security element (4a, 4b) as soon as the exceeding of the predefined threshold value (X) is recognized,
**characterized in that**
the data set is requested by the server entity (2) for ascertaining the functional state of the security element (4a, 4b),
wherein, in dependence on the data set, applications (Appl) and/or services on the security element (4a, 4b) are adapted.

2. The method according to any of the preceding claims, **characterized in that** the access detection unit organizes the individual memory subregions (4310) in accordance with a corresponding counter reading (6) of the detected number of access events (5).

3. The method according to any of the preceding claims, **characterized in that** a management unit (45) of the security element (4a, 4b) stores the detected number of access events (5) by updating a counter reading (6) in a memory subregion (4310) of the nonvolatile memory (431) reserved exclusively for the counter reading (6).

4. The method according to any of the preceding claims, **characterized in that** a management unit (45) of the security element (4a, 4b) stores the detected number of access events (5) by updating a counter reading (7) first in a volatile memory region (430) of the security element (4a, 4b) and a counter reading (6) in the nonvolatile memory subregion (4310) is updated only when a predefined multiple of the counter reading (7) stored in the volatile memory (430) is exceeded.

5. The method according to any of the preceding claims, **characterized in that**
- a management unit (45) of the security element (4a, 4b) stores several detected numbers of access events (5) in different memory subregions (4310) by updating corresponding counter readings (6) in the nonvolatile memory area (431), and
- the management unit (45) stores a counter reading (6) to be updated in a memory subregion (4310) which has a smaller number of access events (5) compared to the update rate of the counter reading (6).

6. The method according to any of the preceding claims, **characterized in that** a management unit (45) of the security element (4a, 4b) and/or the remote server entity (2) prevents an access event (5) to a memory subregion (4310) as soon as the predefined threshold value (X) is exceeded.

7. The method according to any of the preceding claims, **characterized in that** the adaptation of the memory use takes place by storing files (EF) and/or variables (Var) of a predefined type in different memory subregions (4310).

8. The method according to any of the preceding claims, **characterized in that** the adaptation of the memory use takes place in such a manner that a file (EF) and/or a variable (Var) is stored in a memory subregion (4310) different from the original memory subregion (4310) as soon as the detected number of access events (5) in the original memory subregion (4310) exceeds the predefined threshold value (X).

9. The method according to any of the preceding claims, **characterized in that** the adaptation of the memory use takes place in such a manner that files (EF) and/or variables (Var) which were originally stored in a shared memory subregion (4310) are divided to several different memory subregions (4310) as soon as the detected number of access events (5) exceeds the predefined threshold (X).

10. The method according to any of the preceding claims, **characterized in that** the data set is transmitted to the remote server entity (2) by means of a network connection (3) suitable for exchanging the data set.

11. A system comprising:
- at least one security element (4a, 4b) having an integrated semiconductor circuit (41):
- with a nonvolatile memory (431) for storing data;
- with a central processing unit (46); and
- at least one interface (42) for transmitting a data set relating to a functional state of the security element (4);
- wherein the central processing unit (46) has an access detection unit (44) for detecting a number of access events (5) to memory subregions (4310) of the nonvolatile memory region (431);
- wherein the data set comprises the detected number of access events (5); and
- wherein the nonvolatile memory (431) is adaptable when a predefined threshold value (X) of the detected number of access events (5) is exceeded;
- and comprising a remote server entity (2) for obtaining the data set;
- and comprising a network (3) by which at least temporarily a data connection between the security element (4) and the remote server entity (2) is configured,
- wherein the access event (5) is a write access event and the write access event can be initiated on the terminal side, server side and/or security element side,
- wherein the security element (4a, 4b) is configured to automatically send the data set as soon as the exceeding of the predefined threshold value (X) is recognized,
**characterized in that:**
the data set can be requested by the server entity (2) for ascertaining the functional state of the security element (4a, 4b),
wherein the server entity is configured to adapt applications (Appl) and/or services on the security element (4a, 4b) in dependence on the data set.

## Revendications

1. Procédé de prolongement de la durée de fonctionnement d'un élément de sécurité (4a, 4b) comportant un circuit intégré à semi-conducteur (41), comprenant les étapes de procédé :
- détection d'un état de fonctionnement du circuit intégré à semi-conducteur (41) de l'élément de sécurité (4a, 4b) :
- mise à disposition d'un jeu de données par l'élément de sécurité (4a, 4b) pour une instance de serveur (2) éloignée, cependant que le jeu de données contient l'état de fonctionnement ;
- cependant que l'état de fonctionnement comprend le nombre d'événements d'accès (5) à au moins une zone partielle de mémoire (4310) d'une mémoire non volatile (431) de l'élément de sécurité (4a, 4b), cependant que le nombre est détecté au moyen d'une unité de détection d'accès (44) de l'élément de sécurité (4a, 4b) ; et
- cependant que l'utilisation de la mémoire non volatile (431) est adaptée quand il y a dépassement d'une valeur seuil (X) prédéfinie du nombre détecté d'événements d'accès (5),
- cependant que l'événement d'accès (5) est un événement d'accès en écriture et que l'événement d'accès en écriture est initié de la part du terminal, du serveur et/ou de l'élément de sécurité,
- cependant que le jeu de données est envoyé automatiquement par l'élément de sécurité (4a, 4b) dès que le dépassement de la valeur seuil (X) prédéfinie est reconnue,
**caractérisé en ce que**
le jeu de données est demandé par l'instance de serveur (2) pour la détermination de l'état de fonctionnement de l'élément de sécurité (4a, 4b),
cependant que, en fonction du jeu de données, des applications (Appl) et/ou des services sont adaptés sur l'élément de sécurité (4a, 4b).

2. Procédé selon une des revendications précédentes, **caractérisé en ce que** l'unité de détection d'accès ordonne les zones partielles de mémoire (4310) distinctes d'une manière qui correspond à une indication correspondante du compteur (6) du nombre détecté d'événements d'accès (5).

3. Procédé selon une des revendications précédentes, **caractérisé en ce qu'**une unité de gestion (45) de l'élément de sécurité (4a, 4b) enregistre le nombre détecté des événements d'accès (5) par actualisation d'une indication du compteur (6) dans une zone partielle de mémoire (4310), réservée exclusivement pour l'indication du compteur (6), de la mémoire non volatile (431).

4. Procédé selon une des revendications précédentes, **caractérisé en ce qu'**une unité de gestion (45) de l'élément de sécurité (4a, 4b) enregistre le nombre détecté des événements d'accès (5) par actualisation d'une indication du compteur (7) tout d'abord dans une zone volatile de mémoire (430) de l'élément de sécurité (4a, 4b), et que ce n'est que quand il y dépassement d'un multiple prédéfini de l'indication du compteur (7) enregistrée dans la mémoire volatile (430) qu'une indication du compteur (6) est actualisée dans la zone partielle non volatile de mémoire (4310).

5. Procédé selon une des revendications précédentes, **caractérisé en ce que**
- une unité de gestion (45) de l'élément de sécurité (4a, 4b) enregistre plusieurs nombres détectés d'événements d'accès (5) dans différentes zones partielles de mémoire (4310) par actualisation d'indications de compteur (6) correspondantes dans la zone non volatile de mémoire (431), et
- l'unité de gestion (45) enregistre dans une zone partielle de mémoire (4310) présentant par rapport au taux d'actualisation de l'indication du compteur (6) un nombre moindre d'événements d'accès (5) une indication du compteur (6) à enregistrer.

6. Procédé selon une des revendications précédentes, **caractérisé en ce qu'**une unité de gestion (45) de l'élément de sécurité (4a, 4b) et/ou une instance de serveur (2) éloignée empêche un événement d'accès (5) à une zone partielle de mémoire (4310) dès que la valeur seuil (X) prédéfinie est dépassée.

7. Procédé selon une des revendications précédentes, **caractérisé en ce que** l'adaptation de l'utilisation de la mémoire a lieu **en ce que** des fichiers (EF) et/ou des variables (Var) d'un type prédéfini sont enregistré(e)s dans différentes zones partielles de mémoire (4310).

8. Procédé selon une des revendications précédentes, **caractérisé en ce que** l'adaptation de l'utilisation de la mémoire a lieu de telle façon qu'un fichier (EF) et/ou une variable (Var) est enregistré(e) dans une zone partielle de mémoire (4310) différente de la zone partielle d'origine de mémoire (4310) dès que le nombre détecté d'événements d'accès (5) dans la zone partielle d'origine de mémoire (4310) dépasse la valeur seuil (X) prédéfinie.

9. Procédé selon une des revendications précédentes, **caractérisé en ce que** l'adaptation de l'utilisation de la mémoire a lieu de telle façon que des fichiers (EF) et/ou des variables (Var) qui furent à l'origine enregistré(e)s dans une zone partielle commune de mémoire (4310) sont réparti(e)s sur plusieurs zones partielles différentes de mémoire (4310) dès que le nombre détecté d'événements d'accès (5) excède la valeur seuil (X) prédéfinie.

10. Procédé selon une des revendications précédentes, **caractérisé en ce que** le jeu de données est transmis à l'instance de serveur (2) éloignée au moyen d'une connexion réseau (3) appropriée à l'échange du jeu de données.

11. Système comprenant :
- au moins un élément de sécurité (4a, 4b) ayant un circuit intégré à semi-conducteur (41) :
- ayant une mémoire non volatile (431) pour l'enregistrement de données ;
- ayant une unité centrale de calcul (46) ; et
- ayant au moins une interface (42) pour la transmission d'un jeu de données concernant un état de fonctionnement de l'élément de sécurité (4) ;
- cependant que l'unité centrale de calcul (46) comporte une unité de détection d'accès (44) pour la détection d'un nombre d'événements d'accès (5) à des zones partielles de mémoire (4310) de la zone non volatile de mémoire (431) ;
- cependant que le jeu de données comprend le nombre détecté des événements d'accès (5) ; et
- cependant que la mémoire non volatile (431) peut être adaptée quand il y a dépassement d'une valeur seuil (X) prédéfinie du nombre détecté d'événements d'accès (5) :
- et comprenant une instance de serveur (2) éloignée destinée à la réception du jeu de données ; et
- et comprenant un réseau (3) par lequel, au moins temporairement, une connexion de données entre l'élément de sécurité (4) et l'instance de serveur (2) éloignée est réalisée,
- cependant que l'événement d'accès (5) est un événement d'accès en écriture et que l'événement d'accès en écriture peut être initié de la part du terminal, du serveur et/ou de l'élément de sécurité,
- cependant que l'élément de sécurité (4a, 4b) est réalisé pour envoyer le jeu de données automatiquement dès que le dépassement de la valeur seuil (X) prédéfinie est reconnue,
**caractérisé en ce que** :
le jeu de données peut être demandé par l'instance de serveur (2) pour la détermination de l'état de fonctionnement de l'élément de sécurité (4a, 4b),
cependant que l'instance de serveur est réalisée pour adapter des applications (App1) et/ou des services sur l'élément de sécurité (4a, 4b) en fonction du jeu de données.
